(19) Europäisches Patentamt
European Patent Office
Office européen des brevets

(11) **EP 4 589 380 A1**

(12) **EUROPEAN PATENT APPLICATION**

(43) Date of publication:
**23.07.2025 Bulletin 2025/30**

(21) Application number: **24152530.2**

(22) Date of filing: **18.01.2024**

(51) International Patent Classification (IPC):
*G03F 7/00* (2006.01)        *G01N 21/95* (2006.01)

(52) Cooperative Patent Classification (CPC):
**G03F 7/70633; G01N 21/9501; G03F 7/70683**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventors:
• **NIENHUYS, Han-Kwang**
**5642AK Veldhoven (NL)**
• **VAN DER POST, Sietse**
**5642AK Veldhoven (NL)**

(74) Representative: **ASML Netherlands B.V.**
**Corporate Intellectual Property**
**P.O. Box 324**
**5500 AH Veldhoven (NL)**

(54) **METROLOGY METHODS AND ASSOCIATED APPARATUS**

(57) A metrology method, and associated metrology apparatus, for determining one or more parameters of a periodic target on an object is disclosed. The periodic target is adjacent to a reference mark having a pitch equal to that of the periodic target. The method comprises projecting (1100) radiation onto the object such that a first portion of the radiation is incident on the periodic target and a second portion of the radiation is incident on the reference mark. The method further comprises measuring (1200) at least one interference pattern formed by contributions to a single diffraction order from both the first and second portions of radiation. The method further comprises determining (1300) the one or more parameters in dependence on the at least one interference pattern.

1000

1100

1200

1300

**Fig. 8**

**Description**

FIELD

The present invention relates to a new metrology method for determining one or more parameters of a periodic target on an object. The present invention also relates to an associated metrology apparatus for determining one or more parameters of a periodic target on an object. The new method and apparatus may have application in a metrology tool for inspection of silicon wafers during production of integrated circuits using lithography. In particular, the new method and apparatus may have application in such metrology apparatus that is intended to determine overlay (a measure of how well aligned two or more successively formed lithographic layers are).

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as $CD = k_1 \times \lambda/NA$, where $\lambda$ is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low ki.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating/target medium, thereby generating an emitted radiation, optionally a high harmonic generation (HHG) comprising high frequency radiation.

It may be desirable to provide new metrology methods and apparatus for determining one or more parameters of a periodic target (for example on a wafer) that at least partially addresses one or more problems associated with known arrangements, whether such problems are identified herein or otherwise.

<u>SUMMARY</u>

According to a first aspect of the present disclosure there is provided a metrology method for determining one or more parameters of a periodic target on an object, the periodic target being adjacent to a reference mark having a pitch equal to that of the periodic target, the method comprising: projecting radiation onto the object such that a first portion of the radiation is incident on the periodic target and a second portion of the radiation is incident on the reference mark; measuring at least one interference pattern formed by contributions to a single diffraction order from both the first and second portions of radiation; and determining the one or more parameters in dependence on the at least one interference pattern.

The method according to the first aspect is advantageous as now discussed. Since the reference mark has a pitch equal to that of the periodic target, the two structures may produce diffraction patterns comprising diffraction beams scattered at substantially the same angles. In the far field, each diffraction beam from the periodic target may generally spatially overlap with a corresponding diffraction beam from the reference mark. Together, a pair of corresponding diffraction beams from the periodic target and the reference mark may be referred to as an interference beam. Furthermore, in the far field, each of the interference beams may be spatially separate (at a sufficient distance from the object).

The method may be considered to be an interferometric method, with at least one pair of mutually interfering beams (within each interference beam). From the interference pattern, and the profile of the radiation projected onto the target, the phase difference between contributions from the reference mark and the periodic target can be determined. If the structure of the reference mark is known then the phase of the contribution to each diffraction beam from the reference mark can be determined. Furthermore, from this the phase of the contribution to each diffraction beam from the periodic target can be determined.

This method may have application in a metrology tool for inspection of silicon wafers during production of integrated circuits using lithography. In particular, it may have application in such metrology apparatus that is intended to determine overlay (a measure of how well aligned two or more successively formed lithographic layers are). The one or more parameters determined by the method according to the first aspect may include any of the following: a critical dimension (CD), an overlay (i.e. an amount by which two or more process layers are misaligned) and/or a thickness of one or more process layers.

Some such metrology tools use soft x-ray (SXR) metrology, using radiation with a spectral range of the order of 10-20 nm (e.g. comprising a plurality of discrete wavelength components) to illuminate a periodic target on the wafer. A diffraction pattern is captured and spectrally analyzed. Various methods exist to extract these parameters from the scatterometric data. For example, a target response spectrum may be captured in the form of a diffraction efficiency $\eta(m_x, m_y, \lambda)$, where $m_x$, $m_y$ are discrete integer diffraction orders, and $\lambda$ is the wavelength. The data thus acquired contains information about parameters of interest such as overlay and critical dimension.

However, with such known techniques only intensities of the diffracted light are captured.

In contrast, the method according to the first aspect allows for the phase of the diffracted radiation, which also contains useful information, to be measured. Furthermore, it provides a relatively simple and cost effective method to determine such phase information. For example, one known approach to determine the phase response of a target would be to use a method such as digital holographic microscopy (DHM). However, there are a number of problems with applying such a technique using soft x-rays. First, it would require a beam splitter for soft x-rays, which is difficult. Second, it would require two beam paths that are interferometrically stable to < < 10 nm path length difference, which would be very expensive. Third, the fringe pattern on the image sensor would have a period of < 100 nm, which would require an image sensor with unfeasibly small pixel to resolve the fringes.

The at least one interference pattern may be measuring with any suitable detector array or camera.

Projecting the radiation onto the object may comprise focusing the radiation on the object (such that a first portion of the radiation is incident on the periodic target and a second portion of the radiation is incident on the reference mark). That is, the object may be disposed at, or close to, a beam waist of the radiation. For such embodiments, the at least one interference pattern may be measured in the far field. In particular, the at least one interference pattern may be measured at a position that is not within the Rayleigh length of the radiation.

Determining the one or more parameters from the at least one interference pattern may comprise: for each at least one interference pattern, determining phase difference between the contributions to the diffraction beam from the first and second portions of radiation.

Determining the one or more parameters from the at least one interference pattern may comprise: for each at least one interference pattern, determining a position of the interference pattern.

For example, each interference pattern is formed by contributions to a single diffraction order from both the first and second portions of radiation. Each diffraction beam may, in the far field illuminate a spot region (for example circular or elliptical) on a detector. Each such spot region corresponds to a projection of a beam spot region (of the radiation projected onto the object) onto the detector.

Within each such spot region, if the contributions from the first and second portions of radiation are in phase, then the intensity distribution in the spot region may generally match that of the radiation that is projected onto the object (e.g. a Gaussian beam distribution). However, the inventors have realized that, if the contributions from the first and second portions of radiation are out of phase, then a dark fringe may appear in the intensity distribution in the spot region in a direction that corresponds to a separation direction of the periodic target and the reference mark. For example, if the radiation projected on the object has a Gaussian profile then one would expect the intensity distribution in the spot region in a direction that corresponds to a separation direction of the periodic target and the reference mark to have two separate peaks separated by a dark fringe.

For example, if the periodic target and the reference mark are disposed at substantially the same x position on the object but at different y positions then the two peaks may be separated in a direction on the detector that corresponds to the y-direction. By determining a position (in a separation direction of the periodic target and the reference mark) and/or the relative intensity of the peaks of the interference pattern within the spot region, a relative phase of the contributions to the diffraction beam from the first and second portions of radiation can be inferred or determined.

Determining the one or more parameters from the at least one interference pattern may comprise: fitting an expected distribution to the intensity distribution in a spot region corresponding to that diffraction beam in a direction that corresponds to a separation direction of the periodic target and the reference mark; and determining the one or more parameters of the periodic target from one or more parameters of the expected distribution.

The expected distribution may, in general, be dependent on a spatial intensity profile of the radiation projected onto the object.

In some embodiments, the radiation may comprise soft x-rays. It will be appreciated that the radiation comprises sufficiently coherent radiation to produce the at least one interference pattern.

The radiation may comprise radiation in a spectral range of 10-20 nm.

It will be appreciated that the radiation comprising radiation in a spectral range of 10-20 nm is intended to mean that the radiation comprises at least one wavelength component (which may be monochromatic) in the range 10-20 nm. In some embodiments the radiation comprises radiation in a spectral range of 9-18 nm.

The radiation may comprise a plurality of discrete wavelength components.

For example, a spectrum of the radiation may comprise a plurality of discrete peaks, each of which may be referred to as a discrete wavelength component. This may be referred to as a comb structure (although it will be appreciated that each of the peaks may have a non-zero bandwidth). The radiation may comprise radiation in a spectral range of 10-20 nm. The plurality of discrete peaks (or wavelength components) may have a typical spacing of the order of 0.5 nm. There radiation may comprise of the order of 20 such wavelength components. A bandwidth of each peak (discrete wavelength component) of the spectrum may be of the order of 0.1 nm or less.

The method may comprise: measuring at least one interference pattern for each of the plurality of discrete wavelength components, each of the at least one interference patterns being formed by contributions to a single diffraction order for a single discrete wavelength component from both the first and second portions of radiation; and determining the one or more parameters from the at least one interference pattern for each of the plurality of discrete wavelength components.

Advantageously, this allows the phase response to be determined as a function of wavelength.

The method may comprise: measuring a plurality of interference patterns, each one formed by contributions to a single diffraction order from both the first and second portions of radiation; and determining the one or more parameters from the plurality of interference patterns.

For 1D patterns, a shearing direction of the periodic target and reference mark may be defined as a direction that is generally perpendicular to the lines of the patterns.

A shearing direction of each of the periodic target and reference mark may be perpendicular to a separation direction of the periodic target and the reference mark.

Such an arrangement is advantageous if the radiation projected onto the object comprises a plurality of wavelength components. For diffraction orders above the $0^{th}$ order, the different wavelength components may be separated in the far field in the shearing direction but the two peaks formed by the first and second portions of radiation being out of phase may be separated in the separation direction. It may therefore be easier to determine the relative phase of the first and second portions of radiation if the shearing and separation directions are mutually perpendicular.

Alternatively, in some other embodiments the shearing directions of the periodic target and reference mark may be parallel to the separation direction of the periodic target and the reference mark.

In some embodiments the separation direction of the periodic target and the reference mark is in a plane of incidence of the radiation. With such embodiments, for a general diffraction order, there may be an optical path length difference between the first and second portions of the radiation and the radiation has a coherence length that is greater than this optical path length difference.

Alternatively, in some embodiments the separation direction of the periodic target and the reference mark is perpendicular to the plane of incidence of the radiation. Such embodiments may allow of the coherence length of the radiation to be shorter.

Determining the one or more parameters from the at least one interference pattern may be achieved in a number of ways. First, raw data, which comprises one or more images of interference patterns from a detector, may be determined. Second, the one or more parameters may be determined or inferred from the raw data in one of a number of different ways. As discussed above, the one or more parameters may comprise information about the phase of the contribution to the diffraction beam(s) from the first portion of radiation (which is incident on the periodic target).

Determining the one or more parameters may comprise using a trained machine learning model.

The method may further comprise training the machine learning model using training data.

For example, a plurality of different known calibration targets (for which the one or more parameters such as, for example, phase information are known) may be used to generate raw data. The machine learning model may be trained using this learning raw data, along with the known parameters.

Determining the one or more parameters may comprise, for each at least one interference pattern: using a model-based reconstruction of the reference mark to determine a phase response of the contribution to that interference pattern from the reference mark; and combining the determined phase response with the interference pattern so as to determine a phase response of the contribution to that interference pattern from the periodic target.

A simple resist grating (which may be used as the reference mark) has very few unknown parameters. In principle, it is possible to construct a complex-valued diffraction efficiency $r(m_x, m_y, \lambda)$ for such a mark, such that the diffraction efficiency, $\eta$, is given by $\eta = |r|^2$.

The metrology method may further comprise generating the radiation.

Generating the radiation may comprise generating a laser beam having a first wavelength and converting at least a portion of the laser beam into a plurality of different radiation components. The conversion of at least a portion of the laser beam into a plurality of different radiation components may be achieved using high harmonic generation.

The metrology method may further comprise: projecting radiation onto the object such that it is incident on the periodic target; measuring at least one diffraction beam; and determining the one or more parameters in dependence on the at least one diffraction beam.

Since the radiation is projected onto the object such that it is incident on the periodic target (not both the periodic target and the reference mark), this may allow for the diffraction efficiencies $\eta(m_x, m_y, \lambda)$ of the periodic target to be determined in any known way. In turn, this may aid in determining the phase information relating to the periodic target from the at least one interference pattern.

The metrology method may further comprise: projecting radiation onto the object such that it is incident on the reference mark; measuring at least one reference diffraction beam; and determining the one or more parameters in dependence on the at least one reference diffraction beam.

Since the radiation is projected onto the object such that it is incident on the reference mark (not both the periodic target and the reference mark), this may allow for the diffraction efficiencies $\eta(m_x, m_y, \lambda)$ of the reference mark to be determined in any known way. In turn, this may aid in determining the phase information relating to the periodic target from the at least one interference pattern.

In some embodiments, the periodic target may be adjacent to a second reference mark having a pitch equal to that of the periodic target, the second reference mark having a fixed, non-zero spatial phase shift relative to the reference mark. For such embodiments, the method may further comprise: projecting radiation onto the object such that a first portion of the radiation is incident on the periodic target and a second portion of the radiation is incident on the second reference mark; measuring at least one second interference pattern formed by contributions to a single diffraction order from both the first and second portions of radiation; and determining the one or more parameters in dependence on the at least one second interference pattern.

This is particularly advantageous since the interference patterns typically only comprise a single dark fringe and, therefore, the information derived from a measurement using only the periodic target and the reference mark may be under-constrained and it may not be possible to uniquely determine the phase of the contribution from the periodic target relative to the reference mark. However, by repeating the measurement with a second reference mark having a different spatial phase to the reference mark it is possible to measure both the phase and amplitude of the fringes, even if only a partial fringe is visible.

The spatial phase shift of the second reference mark relative to the reference mark may be approximately 90°. With such a phase shift, the fringe pattern observed when using the second reference mark (which may be referred to as a second fringe pattern) is shifted relative to the fringe pattern observed when using the reference mark (which may be referred to as a first fringe pattern). Therefore, if a part of the first pattern is dark (light) then a corresponding part of the second pattern may be light (dark). It will be appreciated that the spatial phase shift of the second reference mark relative to the reference mark does not need to be exactly 90 °.

The metrology method may further comprise: projecting radiation onto the object such that it is incident on the second reference mark; measuring at least one second reference diffraction beam; and determining the one or more parameters in dependence on the at least one second reference diffraction beam.

The reference mark(s) may comprise a simple pattern. For example, the reference mark(s) may comprise a square grating with a 50% duty cycle. The reference mark(s) may comprise a grating structure formed in a layer of photoresist on a substrate.

The pitch of the periodic target (and the reference mark(s)) may typically be in the range 20 to 2000 nm, for example in the range 40 to 400 nm. The periodic target may comprise a one-dimensional (1D) pattern or a two-dimensional (2D) pattern.

According to a second aspect of the present disclosure there is provided a metrology apparatus for determining one or more parameters of a periodic target on an object, the metrology apparatus comprising: illumination optics arranged to project a radiation beam onto the object; a detector array arranged to receive a portion of the radiation beam scattered from the object comprising at least one diffraction beam; and a controller operable to determine the one or more parameters in dependence an interference pattern formed in at least one of the plurality of diffraction beams.

The apparatus according to the second aspect of the present disclosure may be used to carry out the method according to the first aspect.

At least one reference mark may be disposed on the object adjacent to the periodic target. Each of the plurality of diffraction beams may comprise a first portion of radiation scattered from the periodic target and a second portion of radiation scattered from the reference mark.

The illumination optics may be arranged to focus the radiation beam on the object.

That is, the object may be disposed at, or close to, a beam waist of the radiation. For such embodiments, the detector array may be disposed in the far field. In particular, the detector array may be disposed at a position that is not within the Rayleigh length of the radiation from the object.

The detector array may be arranged such that it can resolve the interference pattern formed by the periodic target and an adjacent reference pattern. As discussed above, such an interference pattern may comprise a single dark fringe. To resolve that fringe, the detector array may be disposed at a position such that at least three sensing elements (pixels) of the detector array span the full width at half-maximum (FWHM) of a spot region corresponding to the diffraction order in which the interference pattern is formed.

The controller may be operable to carry out any of the steps of the method according to the first aspect of the present disclosure.

The metrology apparatus may further comprise a radiation source operable to generate the radiation beam.

The radiation source may comprise a seed source, for example a laser, operable to generate seed radiation having a first wavelength. The radiation source may comprise a conversion module arranged to convert at least a portion of the seed radiation into a plurality of different radiation components. The conversion of at least a portion of the seed radiation into a plurality of different radiation components may be achieved using high harmonic generation.

In some embodiments, the radiation may comprise soft x-rays. It will be appreciated that the radiation comprises sufficiently coherent radiation to produce the at least one interference pattern.

The radiation beam may comprise radiation in a spectral range of 10-20 nm.

It will be appreciated that the radiation comprising radiation in a spectral range of 10-20 nm is intended to mean that the radiation comprises at least one wavelength component (which may be monochromatic) in the range 10-20 nm. In some embodiments the radiation comprises radiation in a spectral range of 9-18 nm.

The radiation may comprise a plurality of discrete wavelength components.

The metrology apparatus may further comprise a support for supporting an object such that it is positionable such that the illumination optics can project the radiation beam onto the object.

The support for supporting a substrate may comprise a substrate holder operable to secure the substrate. For example, the support may comprise a clamp for clamping the substrate to the support. The support may comprise a stage such as a wafer stage.

The metrology apparatus may further comprise a movement mechanism operable to cause relative movement of the support and the illumination optics.

This may allow the object or substrate to be stepped or scanned through a beam spot region of the illumination optics. As used herein scanning of an object is intended to mean continuous movement of the object. As used herein stepping of an object is intended to mean movement of the object in a plurality of successive (temporally separated) steps.

According to a third aspect of the present disclosure there is provided a computer-readable medium having instructions for carrying out the method of the second aspect of the present disclosure.

The computer-readable medium may be a non-transitory computer-readable medium. The instructions, upon execution by a computer system, may cause the computer system to carry out the method of any the first aspect of the disclosure.

According to a fourth aspect of the present disclosure there is provided a measurement target for determination of one or more parameters of a manufacturing process, the measurement target comprising: a periodic target; a first reference mark adjacent to the periodic target and having a pitch equal to that of the periodic target; and a second reference mark adjacent to the periodic target and having a pitch equal to that of the periodic target, the second reference mark having a fixed, non-zero spatial phase shift relative to the reference mark.

The measurement target according to the fourth aspect of the present disclosure may comprise any of the features of the periodic target and/or the reference mark and/or the second reference mark of the metrology method according to the first aspect of the present disclosure.

In some embodiments, one or more patterns may be formed on the object in process layers which spatially overlap with the reference mark and/or the second reference mark wherein the one or more patterns have a pitch which is different to that of the reference mark and the second reference mark.

The one or more patterns may be referred to as underlying patterns (as they may be formed below the reference mark and/or second reference mark).

BRIEF DESCRIPTION OF THE DRAWINGS

Embodiments will now be described, by way of example only, with reference to the accompanying schematic drawings, in which:

- Figure 1 depicts a schematic overview of a lithographic system comprising a lithographic apparatus and a radiation source;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figure 8 schematically shows a new metrology method for determining one or more parameters of a periodic target on an object according to an embodiment of the present disclosure;
- Figure 9 schematically shows an example of an object on which is defined a periodic target and to which a reference mark has been applied, the object may correspond to the substrate shown in Figure 6, and the periodic target 2100 may correspond to the target shown in Figure 6;
- Figure 10 schematically shows radiation being projected onto an object such that a first portion of the radiation is incident on a periodic target and a second portion of the radiation is incident on a reference mark;
- Figure 11A schematically shows part of a diffraction pattern that may be produced in the far field by illuminating a periodic target with a radiation beam comprising six discrete wavelength components;
- Figure 11B schematically shows part of a diffraction pattern that may be produced in the far field when a radiation beam comprising six discrete wavelength components is, as shown in Figure 10, projected such that a first portion of the radiation is incident on a periodic target and a second portion of the radiation is incident on an adjacent reference mark having the same pitch;
- Figure 11C schematically shows part of a diffraction pattern that may be produced in the far field when a radiation beam comprising a continuum of wavelength components is, as shown in Figure 10, projected such that a first portion of the radiation is incident on a periodic target and a second portion of the radiation is incident on an adjacent reference mark having the same pitch;

- Figure 12A shows the spot intensity of one of the diffraction beams shown in Figure 11B as a contour plot for the case in which the periodic target is in phase with the reference mark;
- Figure 12B shows the spot intensity of one of the diffraction beams shown in Figure 11B as a contour plot for the case in which there is a phase difference between the periodic target and the reference mark of $\pi/2$;
- Figure 13A shows the intensity as a function of a separation direction in the far field for a case where $R$ = 1 (i.e. a power ratio of 50:50) for four different phase differences $\Delta\phi$ between $r_T$ and $r_R$ (-$\pi/2$, -$\pi/4$, -0 and $\pi/4$);
- Figure 13B shows the intensity as a function of a separation direction in the far field for a case where R = 4 (i.e. a power ratio of 80:20) for four different phase differences $\Delta\phi$ between $r_T$ and $r_R$ (-$\pi/2$, -$\pi/4$, -0 and $\pi/4$);
- Figure 14 schematically shows another example of an object on which is defined a periodic target and to which a reference mark and a second reference mark have been applied, the second reference mark having a fixed, non-zero spatial phase shift relative to the reference mark;
- Figure 15 schematically shows another example of an object on which is defined a periodic target and to which a reference mark has been applied, wherein portions of the process layers surrounding, or adjacent to, the periodic target also comprise marks (for example grating structures); and
- Figure 16 is a schematic illustration of a new metrology apparatus for determining one or more parameters of a periodic target on an object according to an embodiment of the present disclosure.

## DETAILED DESCRIPTION

Before describing embodiments of the invention in detail, it is instructive to present an example environment in which embodiments of the present invention may be implemented.

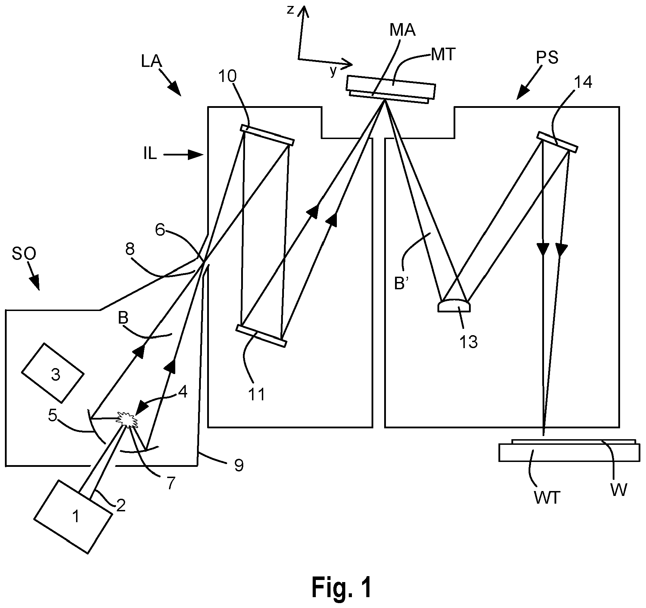

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that may be smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a $CO_2$ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during deexcitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source, high harmonic generation (HHG) source or a free electron laser (FEL) may be used to generate EUV radiation.

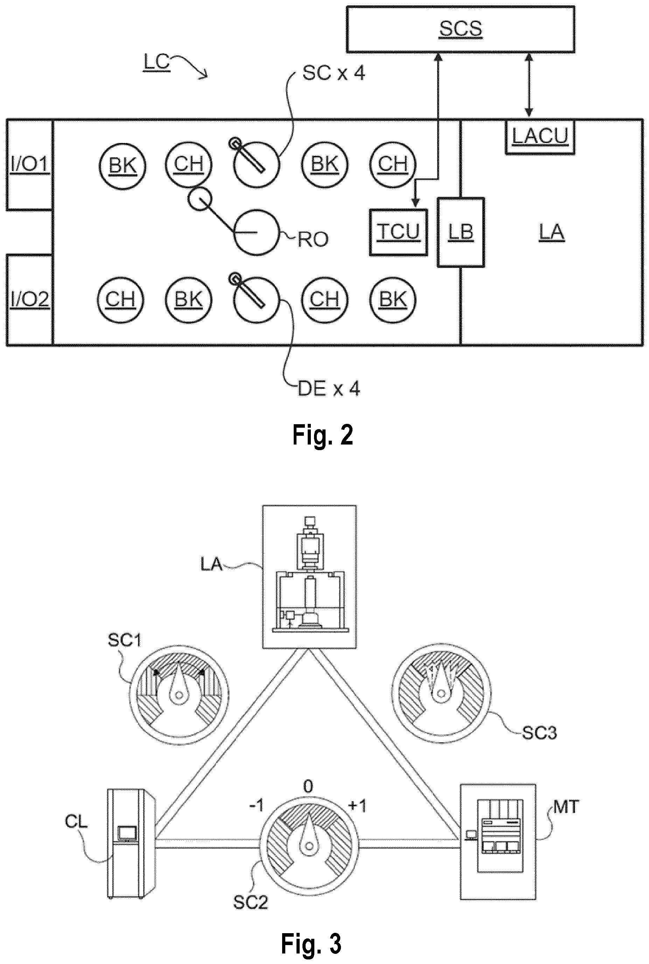

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

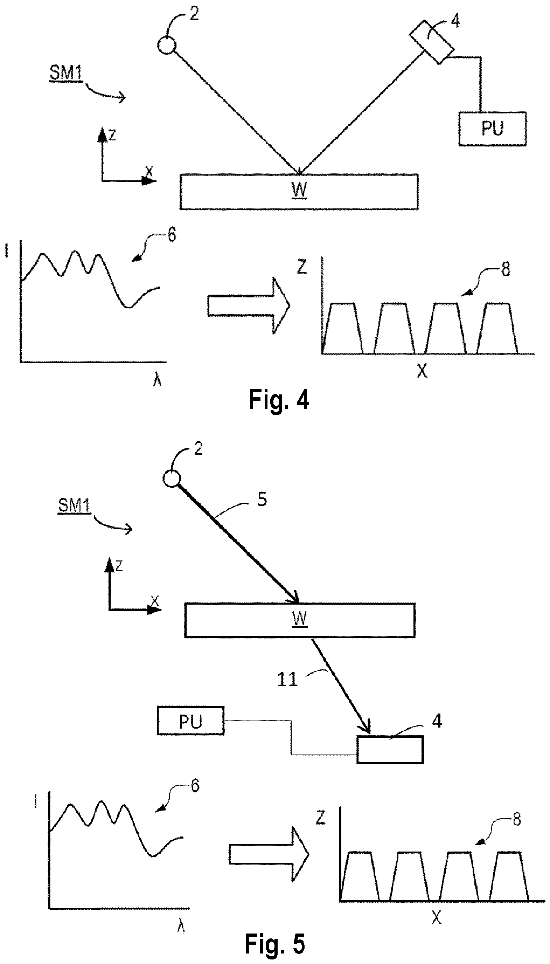

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

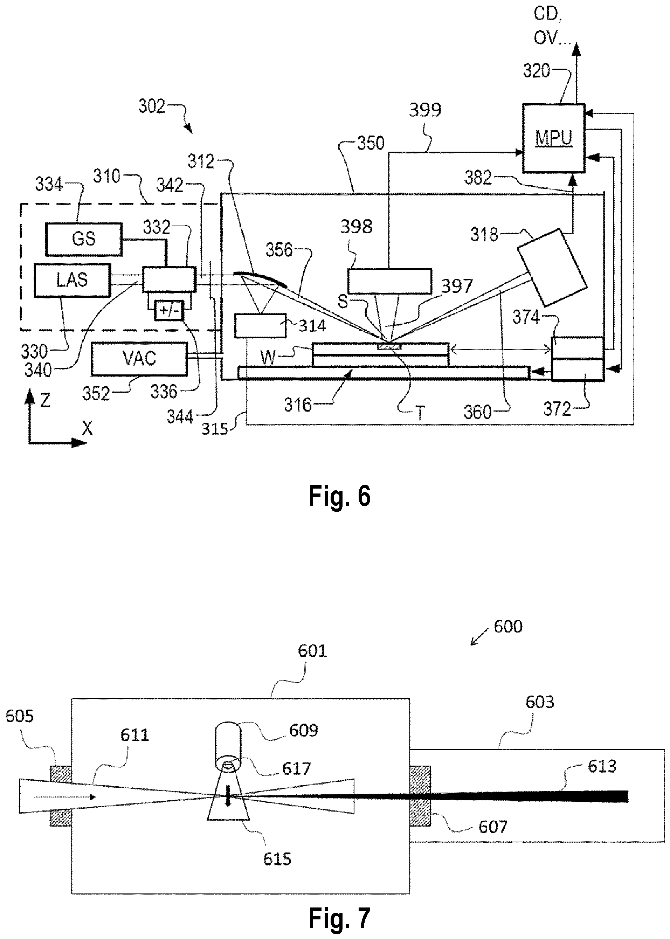

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source, as well as other types of sources, may have a gas target and be a gas jet/nozzle source, a capillary/fiber source or a gas cell source. The HHG source, as well as other types of sources, may have a solid or liquid target. Although HHG source with gas target is described in the text below, it will be appreciated that the invention is not limited to HHG source with gas target and may be used in HHG source with solid or liquid target and other types of source with any target. The gas target, solid target and liquid target may be referred as generating/target medium.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to $10\mu$m, for example in the region of 1 $\mu$m (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, neon (Ne), helium (He), nitrogen ($N_2$), oxygen ($O_2$), argon (Ar), krypton (Kr), xenon (Xe), carbon dioxide and/or any combination of these. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 μm in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target T has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target T may be detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages.

Processor 320 receives highly accurate feedback on the position and orientation of the substrate, via sensors 374. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use HHG or any other types of sources mentioned above to obtain radiation at the desired wavelength(s).

Figure 7 shows a simplified schematic drawing of an embodiment 600 of an illumination source 310, which may be the illumination source for HHG. One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen ($N_2$), Oxygen ($O_2$), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaleddown versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) strongly absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. fewcycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUV, SXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUV, SXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

Although specific reference is made to HHG, it will be appreciated that the invention, where the context allows, may be practiced with all radiation sources. In one embodiment, the radiation source is a laser produced plasma (LPP) source as mentioned above, for hard X-ray, soft X-ray, EUV, DUV as well as visible illumination generation. In one embodiment, the radiation source is one of liquid metal jet source, inverse Compton scattering (ICS) source, plasma channel source, magnetic undulator source, free electron laser (FEL) source, compact storage ring source, electrical discharge produced plasma source, rotating anode source, solid anode source, particle accelerator source, and microfocus source.

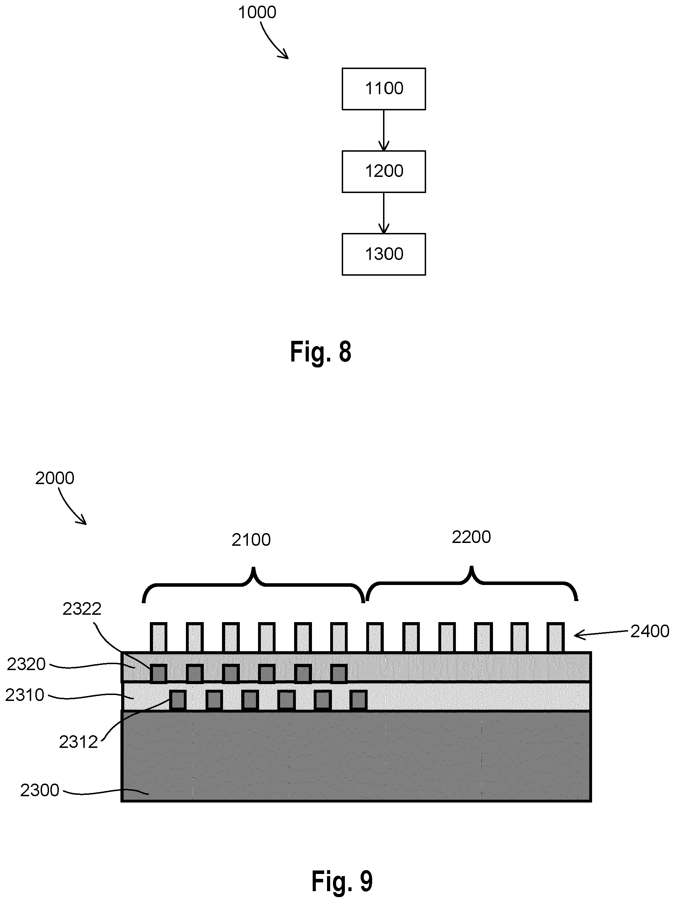

Some embodiments of the present disclosure relate to a new metrology method for determining one or more parameters of a periodic target on an object. An example embodiment of such a new metrology method 1000 is shown schematically in Figure 8.

The new metrology method 1000 is for determining one or more parameters of a periodic target on an object, the periodic target being adjacent to a reference mark having a pitch equal to that of the periodic target.

The new metrology method 1000 comprises a step 1100 of projecting radiation onto the object such that a first portion of the radiation is incident on the periodic target and a second portion of the radiation is incident on the reference mark.

The new metrology method 1000 further comprises a step 1200 of measuring at least one interference pattern formed by contributions to a single diffraction order from both the first and second portions of radiation.

The new metrology method 1000 further comprises a step 1300 of determining the one or more parameters in dependence on the at least one interference pattern.

The one or more parameters (determined at step 1300 of the method 1000 shown in Figure 8) may include any of the following: a critical dimension (CD), an overlay (i.e. an amount by which two or more process layers are misaligned) and/or a thickness of one or more process layers.

Figure 9 schematically shows an example of an object 2000 on which is defined a periodic target 2100 and to which a reference mark 2200 has been applied. The object 2000 may correspond to the substrate W shown in Figure 6. The periodic target 2100 may correspond to the target T shown in Figure 6. In this example, the object 2000 comprises a substrate 2300 on which has been formed one or more process layers 2310, 2320. Each of the process layers 2310, 2320 comprises a periodic pattern 2312, 2322, which each form part of the periodic target 2100.

As used herein the terms "mark" and "target" are synonymous and intended to mean a pattern formed on an object 2000 that can be illuminated with radiation so as to cause the radiation to scatter or diffract. Such objects may be generally planar, meaning that they have two dimensions (which are typically referred to herein as the x and y directions) that are significantly larger than their third dimension (which is typically referred to herein as the z-direction). As used herein the terms "mark" and "target" are intended to mean a pattern formed on an object 2000 that is bounded in a plane of the object (i.e. a region bounded by the x and y directions). It will be appreciated that such objects 2000 have some non-zero thickness and, in general, may comprise a plurality of different layers. One or more of such layers may define a pattern (for example a periodic pattern). For example, one or more of such layers may define diffraction grating structures or the like. In general, if two such patterns formed in different layers are disposed in substantially the same position in the x-y plane then they may contribute to the same mark or target (when radiation is incident on this region of the x-y plane it will see a combination of the patterns and may be scatter from this combination). Therefore, in general, each mark or target on an object comprises a plurality of patterns formed in a plurality of different process layers.

The reference mark 2200 may comprise a simple pattern. For example, the reference mark 2200 may comprise a square grating with a 50% duty cycle. The reference mark 2200 may comprise a grating structure formed in a layer of photoresist 2400 on the substrate 2300. In this embodiment, a grating structure is formed in a layer of photoresist 2400 on the substrate 2300 both: (a) over the periodic patterns 2312, 2322 formed in the process layers 2310, 2320, which form part of the periodic target 2100; and (b) adjacent to these periodic patterns 2312, 2322. The part of the grating structure formed in the layer of photoresist 2400 which overlies the periodic patterns 2312, 2322 formed in the process layers 2310, 2320 also forms part of the periodic target 2100.

The pitch of the periodic target 2100 (and the reference mark 2200) may typically be in the range 20 to 2000 nm, for example in the range 40 to 400 nm. The periodic target 2100 may comprise a one-dimensional (1D) pattern or a two-dimensional (2D) pattern.

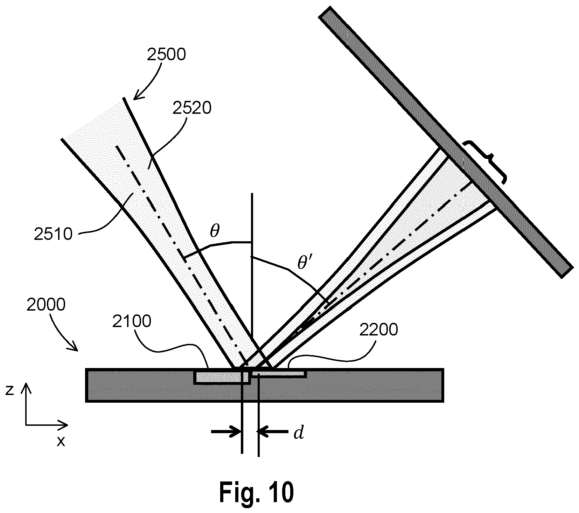

Figure 10 schematically shows radiation 2500 being projected onto an object 2000 such that a first portion of the radiation is incident on a periodic target 2100 and a second portion of the radiation is incident on a reference mark 2200 (for example at step 1100 of new method 1000). In particular, the radiation beam 2500 is focused on the object 2000. That is, the object 2000 may be disposed at, or close to, a beam waist of the radiation beam 2500. For such embodiments, the at least one interference pattern may be measured in the far field (at step 1300 of new method 1000). In particular, the at least one interference pattern may be measured at a position that is not within the Rayleigh length of the radiation 2500.

As shown in Figure 10, a first portion 2510 of the radiation 2500 is incident on the periodic target 2100 and a second portion 2520 of the radiation 2500 is incident on the reference mark 2200.

For ease of understanding, Figure 10 only shows a single diffraction beam (with a diffraction angle of $\vartheta$). It will be appreciated that, in general, a plurality of diffraction beams may be generated by the periodic target 2100 and the reference mark 2200.

The method 1000 shown in Figure 8 is advantageous, as now discussed. Since the reference mark 2200 has a pitch equal to that of the periodic target 2100, the two structures may produce diffraction patterns comprising diffraction beams scattered at substantially the same angles. Therefore, as shown schematically in Figure 10, in the far field, each diffraction beam from the periodic target 2100 may generally spatially overlap with a corresponding diffraction beam from the reference mark 2200. Together, a pair of corresponding diffraction beams from the periodic target 2100 and the reference mark 2200 may be referred to as an interference beam. Furthermore, in the far field, each of the interference beams may be spatially separate (at a sufficient distance from the object 2000).

The method shown in Figure 8 may be considered to be an interferometric method, with at least one pair of mutually interfering beams (within each interference beam). From the interference pattern, and the profile of the radiation 2500 projected onto the object 2000, the phase difference between contributions from the reference mark 2200 and the periodic target 2100 can be determined. If the structure of the reference mark 2200 is known, then the phase of the contribution to each diffraction beam from the reference mark 2200 can be determined. Furthermore, from this the phase of the contribution to each diffraction beam from the periodic target 2100 can be determined.

This method shown in Figure 8 may have application in a metrology tool for inspection of silicon wafers W during production of integrated circuits using lithography. In particular, it may have application in such metrology apparatus (for example a metrology apparatus 302 of the type shown in Figure 6 and described above) that is intended to determine overlay (a measure of how well aligned two or more successively formed lithographic layers are).

Some such metrology tools use soft x-ray (SXR) metrology, using radiation with a spectral range of the order of 10-20 nm (e.g. comprising a plurality of discrete wavelength components) to illuminate a periodic target on the wafer. A diffraction pattern is captured and spectrally analyzed. Various methods exist to extract these parameters from the scatterometric data. For example, a target response spectrum may be captured in the form of a diffraction efficiency $\eta(m_x, m_y, \lambda)$, where $m_x$, $m_y$ are discrete integer diffraction orders, and $\lambda$ is the wavelength. The data thus acquired contains information about parameters of interest such as overlay and critical dimension.

However, with such known techniques only intensities of the diffracted light are captured.

In contrast, the method 1000 shown in Figure 8 allows for the phase of the diffracted radiation, which also contains useful information, to be measured. Furthermore, it provides a relatively simple and cost effective method to determine such phase information. For example, one known approach to determine the phase response of a target would be to use a method such as digital holographic microscopy (DHM). However, there are a number of problems with applying such a technique using soft x-rays. First, it would require a beam splitter for soft x-rays, which is difficult. Second, it would require two beam paths that are interferometrically stable to <<10 nm path length difference, which would be very expensive. Third, the fringe pattern on the image sensor would have a period of <100 nm, which would require an image sensor with unfeasibly small pixel to resolve the fringes.

The at least one interference pattern may be measuring with any suitable detector array or camera.

In some embodiments, the radiation (used at step 1100) may comprise soft x-rays. It will be appreciated that the radiation comprises sufficiently coherent radiation to produce the at least one interference pattern.

In some embodiments, the radiation (used at step 1100) may comprise radiation in a spectral range of 10-20 nm.

In some embodiments, the radiation (used at step 1100) may comprise a plurality of discrete wavelength components. For example, a spectrum of the radiation may comprise a plurality of discrete peaks, each of which may be referred to as a discrete wavelength component. This may be referred to as a comb structure (although it will be appreciated that each of the peaks will have a non-zero bandwidth). The radiation may comprise radiation in a spectral range of 10-20 nm. The plurality of discrete peaks (or wavelength components) may have a typical spacing of the order of 0.5 nm. There radiation may comprise of the order of 20 such wavelength components. A bandwidth of each peak (discrete wavelength component) of the spectrum may be of the order of 0.1 nm or less.

In some embodiments, the radiation (used at step 1100) may be generated by an illumination source 600 of the type shown in Figure 7 and described above.

In some embodiments, the step 1300 of determining the one or more parameters in dependence on the at least one interference pattern may comprises: for each at least one interference pattern, determining a relative phase of the contributions to the diffraction beam from the first and second portions of radiation.

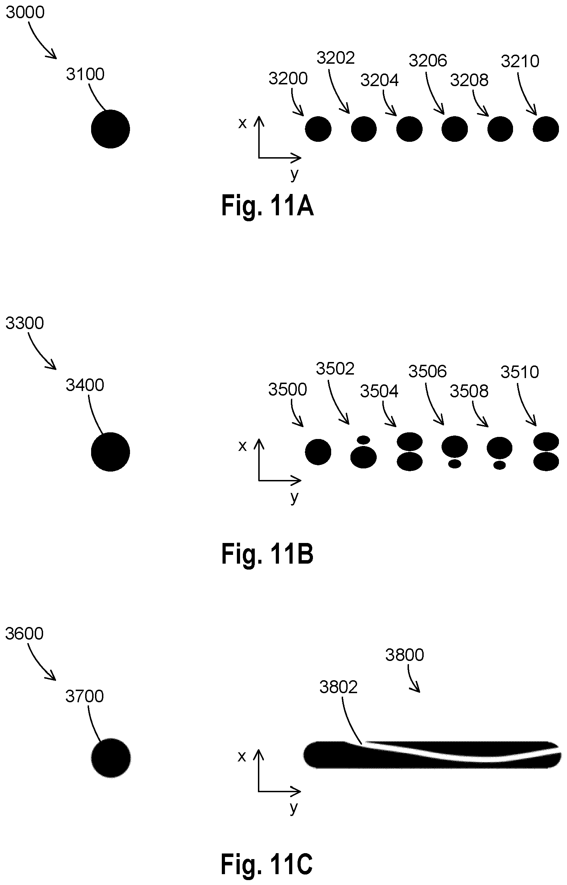

In some embodiments, the step 1300 of determining the one or more parameters in dependence on the at least one interference pattern may comprise: for each at least one interference pattern, determining a position of the interference pattern, as now discussed with reference to Figures 11A to 13B.

Figure 11A schematically shows part of a diffraction pattern 3000 that may be produced in the far field by illuminating a periodic target with a radiation beam comprising six discrete wavelength components. As shown in Figure 11A, the diffraction pattern 3000 comprises a 0th order diffraction beam 3100 (comprising radiation from all six wavelength components) and six 1st order diffraction beams 3200, 3202, 3204, 3206, 3208, 3210 (each corresponding to a different one of the six wavelength components).

It will be appreciated that, in general, there may be many more diffraction orders present in such a diffraction pattern 3000. For example, there may be +1st order diffraction beams and -1st order diffraction beams. Furthermore, there may be higher order diffraction beams ($\pm$2nd order, $\pm$3rd order and so on). Furthermore, it will also be appreciated that, in general, the radiation beam may comprise a different number (other than six) of discrete wavelength components. This simple example only showing two diffraction beams and six wavelength components is presented in Figure 11A for ease of understanding.

Figure 11B schematically shows part of a diffraction pattern 3300 that may be produced in the far field when, as shown in Figure 10, a radiation beam comprising six discrete wavelength components is projected such that a first portion of the radiation is incident on a periodic target and a second portion of the radiation is incident on an adjacent reference mark having the same pitch.

Since the reference mark has a pitch equal to that of the periodic target, the two structures may produce diffraction patterns comprising diffraction beams scattered at substantially the same angles. In particular, as shown in Figure 11B, the diffraction pattern 3300 comprises a 0th order diffraction beam 3400 (comprising radiation from all six wavelength components) and six 1st order diffraction beams 3500, 3502, 3504, 3506, 3508, 3510 (each corresponding to a different one of the six wavelength components). As shown schematically in Figure 10, in the far field, each diffraction beam from the periodic target 2100 may generally spatially overlap with a corresponding diffraction beam from the reference mark 2200. Together, a pair of corresponding diffraction beams from the periodic target 2100 and the reference mark 2200 may be referred to as an interference beam. Furthermore, in the far field, each of the interference beams may be spatially separate (at a sufficient distance from the object 2000). For example the $0^{th}$ order diffraction beam 3400 is spatially separate from the $1^{st}$ order diffraction beams 3500, 3502, 3504, 3506, 3508, 3510.

Furthermore, in this embodiment, since the radiation beam comprises discrete wavelength components, as shown in Figure 11B, in the far field (at a sufficient distance from the object 2000) each of the six $1^{st}$ order diffraction beams 3500, 3502, 3504, 3506, 3508, 3510 (each corresponding to a different one of the six wavelength components) is spatially separate. However, in other embodiments this may not be the case, as discussed further below with reference to Figure 11C.

Although not shown in Figure 11B, the $0^{th}$ order diffraction beam 3400 may change shape as a result of phase differences between the contributions from the periodic target and the reference mark (relative to the $0^{th}$ order diffraction beam 3100 shown in Figure 11A). However, since each wavelength component may, in general, cause a different shape change, the net effect may likely be that the $0^{th}$ order diffraction beam 3400 may be slightly elongated along the x direction.

Each interference pattern is formed by contributions to a single diffraction order from both the first and second portions of radiation. Each diffraction beam may, in the far field illuminate a spot region (for example circular, elliptical or elongate region) on a detector. Each such spot region may correspond to a projection of a beam spot region (of the radiation projected onto the object) onto the detector.

Within each such spot region, if the contributions from the first and second portions of radiation are in phase, then the intensity distribution in the spot region may generally match that of the radiation that is projected onto the object (e.g. a Gaussian beam distribution). This is the case for the first $1^{st}$ order diffraction beam 3500 shown in Figure 11B.

However, the inventors have realized that, if the contributions from the first and second portions of radiation are out of phase, then a dark fringe may appear in the intensity distribution in the spot region in a direction that corresponds to a separation direction of the periodic target 2100 and the reference mark 2200 (see $1^{st}$ order diffraction beams 3502-3510). For example, if the radiation projected on the object has a Gaussian profile then one would expect the intensity distribution in the spot region in a direction that corresponds to a separation direction of the periodic target 2100 and the reference mark 2200 to have two separate peaks separated by a dark fringe.

For example, if the periodic target and the reference mark are disposed at substantially the same y position on the object but at different x positions (as schematically shown in Figure 10) then the two peaks may be separated in a direction on the detector that corresponds to the x-direction (as shown, for example in Figure 11B). By determining a position (in the separation direction) and/or the relative intensity of the peaks of the interference pattern within the spot region, a relative phase of the contributions to the diffraction beam from the first and second portions of radiation can be inferred or determined.

Consider a single diffraction order and a single wavelength, $\lambda$, incident on a periodic target 2100 and a reference mark 2200 that are separated in an x direction (and are disposed at substantially the same y position on the object, i.e. as shown schematically in Figure 10). For this diffraction order, the periodic target and the reference mark have well-defined complex diffraction efficiencies $r_T$ and $r_R$ respectively (as defined at a reference point). The combined patterns are illuminated by the focus of a Gaussian beam, which has a field amplitude $E(x, y)$, where $x, y$ are the coordinate axes in the plane of the wafer, with the origin at said reference point. The far field amplitude E can then be obtained by a Fourier transform as:

$$\tilde{E}\left(q_x, q_y\right) = \int_{\mathbb{R}^2} E(x, y)\, r(x, y)\, e^{2\pi i\left(q_x x + q_y y\right)}\, dx\, dy, \tag{1}$$

where $r(x,y)$ takes values $r_T$ or $r_R$ depending on whether the position $(x, y)$ corresponds to the periodic target or the reference mark. The Fourier-domain coordinates $q_x, q_y$ are related to diffraction angles (relative to the chief ray for this diffraction order) roughly as:

$$|q| \approx \frac{sin(\Delta\theta)}{\lambda}. \tag{2}$$

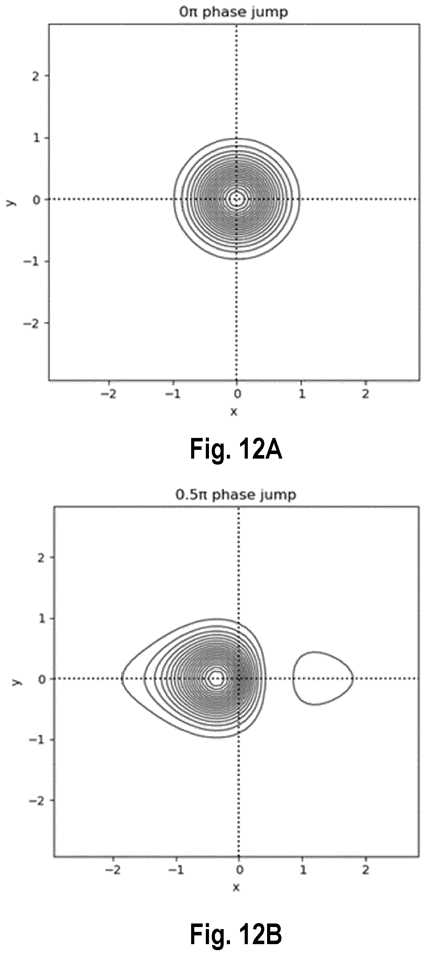

Figure 12A shows the spot intensity $|\tilde{E}|^2$ as a contour plot for the case in which the periodic target is in phase with the reference mark and Figure 12B shows the spot intensity $|\tilde{E}|^2$ as a contour plot for the case in which there is a phase difference between the periodic target and the reference mark of $\pi/2$. As can be seen from Figure 12B, the phase difference between the periodic target and the reference mark leads to a shift of the maximum and the appearance of a dark fringe within the diffraction order.

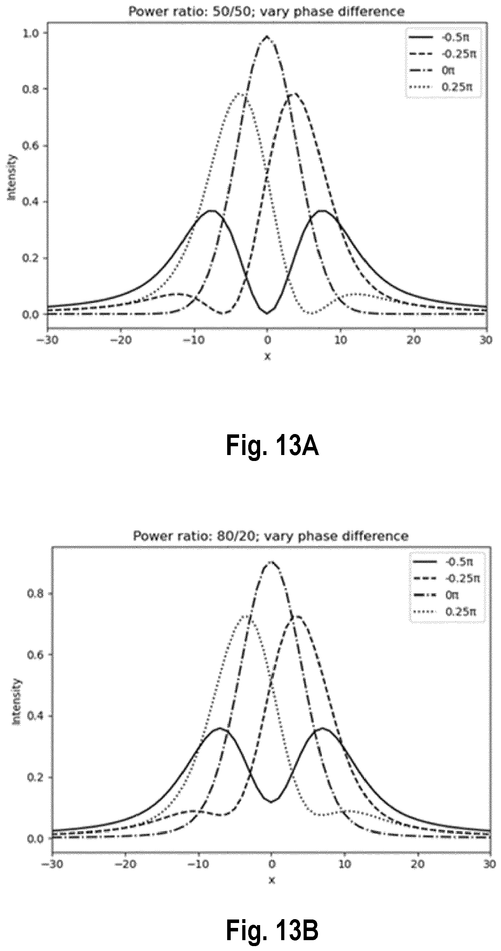

The intensity values as a function of $q_x$ (i.e., $x$ in the far field) may depend on the phase difference between $r_T$ and $r_R$ as well as the ratio of diffraction efficiencies, $R = |r_T|^2/|r_R|^2$. This is illustrated in Figures 13A and 13B. Figure 13A shows the intensity as a function of $q_x$ (i.e., $x$ in the far field) for a case where $R = 1$ (i.e. a power ratio of 50:50) for four different phase differences $\Delta\phi$ between $r_T$ and $r_R$ ($-\pi/2$, $-\pi/4$, 0 and $\pi/4$). Figure 13B shows the intensity as a function of $q_x$ (i.e., $x$ in the far field) for a case where $R = 4$ (i.e. a power ratio of 80:20) for four different phase differences $\Delta\phi$ between $r_T$ and $r_R$ ($-\pi/2$, $-\pi/4$, -0 and $\pi/4$).

For a beam focus that was split across the periodic target and the reference mark, for each wavelength component, an intensity profile in the fringe direction (y-direction Figure 11B) can be obtained. Each such intensity profile may be of the form of those shown in Figures 13A and 13B. Generally, if a line shape as in Figures 13A and 13B can be observed, both the phase difference and the diffraction-efficiency ratio can be inferred from the line shape. Furthermore, the total diffracted energy (proportional to $|r_R|^2 + |r_T|^2$) can be inferred from the area under the curve. Therefore, from each intensity profile, the phase difference $\Delta\phi$ between periodic target and the reference mark, the power ratio R, and total spectral diffraction intensity $I_d$ (in W/nm) can be inferred, by fitting the line shape.

With knowledge of the absolute phase and amplitude response of the reference mark (i.e. of the complex value $r_T$), the phase of the target response $\arg(r_T)$ can be inferred as:

$$\arg(r_T) = \Delta\phi - \arg(r_R). \qquad (3)$$

If the incident spectral intensity $I$ for the wavelength component is known, then the diffraction efficiency of the target is given by either of the following equations:

$$|r_T|^2 = \frac{I_d}{I} - |r_R|^2 \qquad (4)$$

$$|r_T|^2 = R \cdot |r_R|^2. \qquad (5)$$

Equation (4) may be preferred as it is numerically well behaved for $|r_R|^2 \approx 0$.

It will be appreciated that the above analysis (discussion of Figures 11A to 13B) is based on a Gaussian beam. In practice, the beam may be non-Gaussian and/or there may be wavefront aberrations (such as astigmatism) and the intensity profile in the far field may be different from a pure Gaussian one. Furthermore, in practice the incident beam focus may not have a 50/50 split of energy across the periodic target and the reference mark. However, the method outlined above of fitting the shape to obtain a phase difference $\Delta\phi$ and a diffraction-efficiency ratio R can still be obtained for a non-Gaussian beam if the beam shape is known. The power split ratio (50/50 or other) can be used from prior knowledge or can be included as a fit parameter when the line shape is fitted.

As explained above, in some embodiments, determining the one or more parameters from the at least one interference pattern (at step 1300) may comprise: (a) fitting an expected distribution to the intensity distribution in a spot region corresponding to that diffraction beam in a direction that corresponds to a separation direction of the periodic target and the reference mark; and (b) determining the one or more parameters of the periodic target from one or more parameters of the expected distribution.

The expected distribution may, in general, be dependent on a spatial intensity profile of the radiation projected onto the object.

For embodiments wherein the radiation comprises a plurality of wavelength components, the method 1000 shown in Figure 8 may comprise: measuring at least one interference pattern for each of the plurality of discrete wavelength components, each of the at least one interference patterns being formed by contributions to a single diffraction order for a single discrete wavelength component from both the first and second portions of radiation; and determining the one or more parameters from the at least one interference pattern for each of the plurality of discrete wavelength components. Advantageously, this allows the phase response to be determined as a function of wavelength.

Figure 11C schematically shows part of a diffraction pattern 3600 that may be produced in the far field when, as shown in Figure 10, a radiation beam comprising a continuum of wavelength components is projected such that a first portion of the radiation is incident on a periodic target and a second portion of the radiation is incident on an adjacent reference mark having the same pitch.

Since the reference mark has a pitch equal to that of the periodic target, the two structures may produce diffraction patterns comprising diffraction beams scattered at substantially the same angles. In particular, as shown in Figure 11C, the diffraction pattern 3600 comprises a $0^{th}$ order diffraction beam 3700 (comprising radiation from all six wavelength components) and a $1^{st}$ order diffraction beam 3800. As with the embodiment shown in Figure 11B, in the far field, each of the interference beams is spatially separate (at a sufficient distance from the object 2000). For example the $0^{th}$ order diffraction beam 3700 is spatially separate from the $1^{st}$ order diffraction beam 3800.

In this embodiment, since the radiation beam comprises a continuum of wavelength components, as shown in Figure 11C, in the far field the $1^{st}$ order diffraction beams from different wavelengths at least partially overlap to produce a single $1^{st}$ order diffraction beam 3800. As shown schematically in Figure 11C, if the contributions from the first and second portions of radiation are out of phase, then a dark fringe 3802 may appear in the intensity distribution in this single $1^{st}$ order diffraction beam 3800. For any give position in the shearing direction of the periodic target 2100 and the reference mark 2200 (i.e. the y-direction in Figure 11C), the dark fringe 3802 separates two portions that are separated in a direction that corresponds to a separation direction of the periodic target 2100 and the reference mark 2200 (i.e. the x-direction in Figure 11C). Furthermore, the position of this dark fringe in the separation direction (the x-direction) may, in general, vary at different positions corresponding to a shearing direction of the periodic target 2100 and the reference mark 2200 (i.e. the y-direction in Figure 11C).

In some embodiments, the method shown in Figure 8 may comprise: measuring a plurality of interference patterns, each one formed by contributions to a different diffraction order from both the first and second portions of radiation; and determining the one or more parameters from the plurality of interference patterns.

For 1D patterns, a shearing direction of the periodic target 2100 and reference mark 2200 may be defined as a direction that is generally perpendicular to the lines of the patterns.

In some embodiments, a shearing direction of each of the periodic target 2100 and reference mark 2200 is perpendicular to a separation direction of the periodic target 2100 and the reference mark 2200. Such an arrangement is advantageous if the radiation projected onto the object comprises a plurality of wavelength components. For diffraction orders above the $0^{th}$ order, the different wavelength components may be separated in the far field in the shearing direction (for example the y-direction in Figure 11B) but the two peaks formed by the first and second portions of radiation being out of phase may be separated in the separation direction (for example the x-direction in Figure 11B). It may therefore be easier to determine the relative phase of the first and second portions of radiation if the shearing and separation directions are mutually perpendicular.

Alternatively, in some other embodiments the shearing directions of the periodic target 2100 and reference mark 2200 may be parallel to the separation direction of the periodic target and the reference mark.

In some embodiments the separation direction of the periodic target 2100 and the reference mark 2200 is in a plane of incidence of the radiation 2500 (as, for example, shown in Figure 10). The shearing direction of the periodic target 2100 and the reference mark 2200 may be parallel to this separation direction). With such embodiments, for a general diffraction order, there may be an optical path length difference between the first and second portions of the radiation and the radiation have a coherence length that is greater than this optical path length difference. In particular, for an angle of incidence of $\theta$ and an angle of the diffracted radiation of $\theta'$, the coherence length $l_c$ satisfies:

$$l_c > d \left| \sin \theta - \sin \theta' \right| = \frac{dm\lambda}{p}, \tag{6}$$

where $m$ is the diffraction order number, $p$ is the pitch of the periodic target and $\lambda$ is the wavelength. The coherence length $l_c$ may refer to the coherence length of a single peak of the comb spectrum, i.e., $l_c \approx \lambda^2/\Delta\lambda$, where $\Delta\lambda$ is the bandwidth of said single peak.

Alternatively, in some embodiments the separation direction of the periodic target 2100 and the reference mark 2200 may be perpendicular to the plane of incidence of the radiation. Such embodiments may allow of the coherence length of the radiation to be shorter.

Determining the one or more parameters from the at least one interference pattern may be achieved in a number of ways. First, raw data, which comprises one or more images of interference patterns from a detector, may be determined. Second, the one or more parameters may be determined or inferred from the raw data in one of a number of different ways. As discussed above, the one or more parameters may comprise information about the phase of the contribution to the diffraction beam(s) from the first portion of radiation 2510 (which is incident on the periodic target 2100).

In some embodiments, the step 1300 of determining the one or more parameters may comprise using a trained machine learning model. In some embodiments, the method 1000 may further comprise training the machine learning model using training data. For example, a plurality of different known calibration targets (for which the one or more parameters such as, for example, phase information are known) may be used to generate raw data. The machine learning model may be trained using this learning raw data, along with the known parameters.

In some embodiments, the step 1300 of determining the one or more parameters may comprise, for each at least one interference pattern: using a model-based reconstruction of the reference mark 2200 to determine a phase response of the contribution to that interference pattern from the reference mark 2200; and combining the determined phase response with the interference pattern so as to determine a phase response of the contribution to that interference pattern from the periodic target 2100. A simple resist grating (which may be used as the reference mark) has very few unknown parameters. In principle, it is possible to construct a complex-valued diffraction efficiency $r(m_x, m_y, \lambda)$ for such a mark, such that the diffraction efficiency, $\eta$, is given by $\eta = |r|^2$. For such embodiments, which use a model-based reconstruction of the reference mark 2200, the method 1000 may further comprise: projecting radiation onto the object such that it is incident on the periodic target 2100 alone, as described further below.

In some embodiments, the method 1000 may further comprise generating the radiation 2500 (for example, using an illumination source 600 of the type shown in Figure 7 and described above). Generating the radiation 2500 may comprise generating a laser beam having a first wavelength and converting at least a portion of the laser beam into a plurality of different radiation components. The conversion of at least a portion of the laser beam into a plurality of different radiation components may be achieved using high harmonic generation.

In some embodiments, the method 1000 may further comprise: projecting radiation onto the object such that it is incident on the periodic target 2100; measuring at least one diffraction beam; and determining the one or more parameters in dependence on the at least one diffraction beam. This may allow for the diffraction efficiencies $\eta(m_x, m_y, \lambda)$ of the periodic target 2100 to be determined in any known way. In turn, this may aid in determining the phase information relating to the periodic target 2100 from the at least one interference pattern.

In some embodiments, the method 1000 may further comprise: projecting radiation onto the object such that it is incident on the reference mark 2200; measuring at least one reference diffraction beam; and determining the one or more parameters in dependence on the at least one reference diffraction beam. This may allow for the diffraction efficiencies $\eta$ $(m_x, m_y, \lambda)$ of the reference mark to be determined in any known way. In turn, this may aid in determining the phase information relating to the periodic target from the at least one interference pattern.

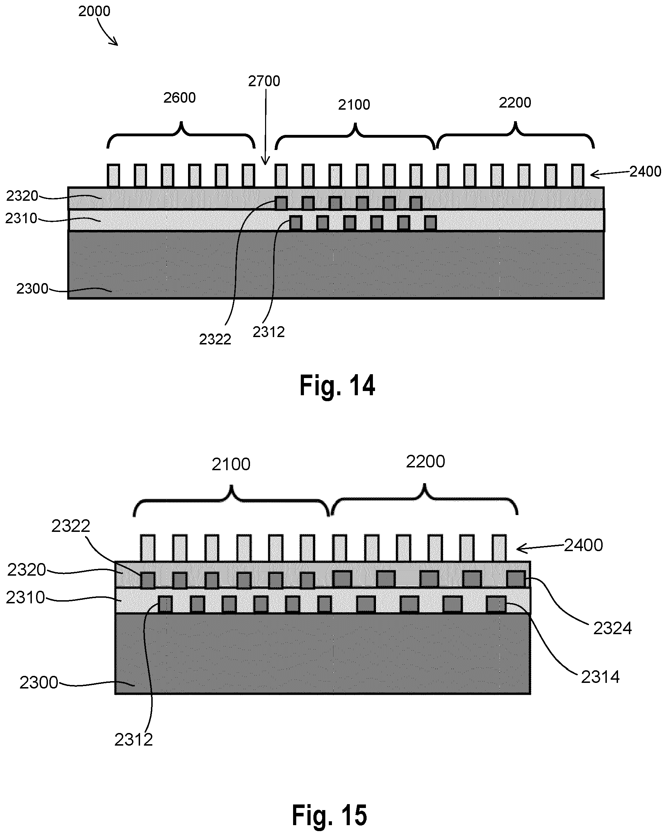

As shown in Figure 14, in some embodiments, the periodic target 2100 is adjacent to a second reference mark 2600 having a pitch equal to that of the periodic target 2100, the second reference mark 2600 having a fixed, non-zero spatial phase shift relative to the reference mark 2200.

For such embodiments, the method 1000 may further comprise: projecting radiation onto the object such that a first portion of the radiation is incident on the periodic target 2100 and a second portion of the radiation is incident on the second reference mark 2600; measuring at least one second interference pattern formed by contributions to a single diffraction order from both the first and second portions of radiation; and determining the one or more parameters in dependence on the at least one second interference pattern.

This is particularly advantageous since the interference patterns typically only comprise a single dark fringe and, therefore, the information derived from a measurement using only the periodic target 2100 and the reference mark 2200 may be under-constrained and it may not be possible to uniquely determine the phase of the contribution from the periodic target relative 2100 to the reference mark 2200. However, by repeating the measurement with a second reference mark 2600 having a different spatial phase to the reference mark 2200 it is possible to measure both the phase and amplitude of the fringes, even if only a partial fringe is visible.

The spatial phase shift 2700 of the second reference mark 2600 relative to the reference mark 2200 may be approximately 90°. With such a phase shift, the fringe pattern observed when using the second reference mark 2600 (which may be referred to as a second fringe pattern) is shifted relative to the fringe pattern observed when using the reference mark 2200 (which may be referred to as a first fringe pattern). Therefore, if a part of the first pattern is dark (light) then a corresponding part of the second pattern may be light (dark). It will be appreciated that the spatial phase shift of the second reference mark relative to the reference mark does not need to be exactly 90 °.

In such embodiments, the method 1000 may further comprise: projecting radiation onto the object such that it is incident on the second reference mark 2600; measuring at least one second reference diffraction beam; and determining the one or more parameters in dependence on the at least one second reference diffraction beam.

In the above described embodiments, the periodic target 2100 comprises periodic patterns 2312, 2322 formed in process layers 2310, 2320 wherein, the parts of these process layers 2310, 2320 which are below the reference mark 2200 have no pattern (referred to herein as pattern-less areas). As such, the reference mark is 2200 defined entirely by a grating structure formed in a layer of photoresist 2400 on the substrate 2300. In practice, such pattern-less areas on a wafer may affect chemical processing adversely in patterned areas adjacent to such pattern-less areas. Therefore, as shown in Figure 15, in some embodiments, rather than no pattern, the portions of the process layers 2310, 2320 surrounding, or adjacent to, the periodic targets may also comprise patterns (for example grating structures) 2314, 2324.

Such embodiments may still work despite the underlying additional patterns 2314, 2324 as long as these underlying additional patterns 2314, 2324 have a pitch which is different from that of the periodic target 2100 (and reference mark 2200). For example, if the periodic target 2100 has x and y pitches of 50 nm and 70 nm respectively, the underlying surrounding patterns 2314, 2324 may have x and y pitches of 65 nm and 81 nm respectively. The pitches of the underlying surrounding patterns 2314, 2324 may be selected such that most diffraction orders from these patterns 2314, 2324 may not overlap with the diffraction orders of the periodic target 2100. Furthermore, an orientation of a unit call of the underlying surrounding patterns 2314, 2324 may differ from that of the periodic target 2100. For example, if the periodic target 2100 unit cell is a rectangle aligned with the x and y axes of the wafer, then the unit cell of the underlying surrounding patterns 2314, 2324 may be a rectangle rotated the axes of which are disposed at an angle (of, for example, 5 to 10 degrees) relative to the x and y axes of the wafer. Again, this may help to ensure that fewer diffraction orders from these patterns 2314, 2324 overlap with the diffraction orders of the periodic target 2100.

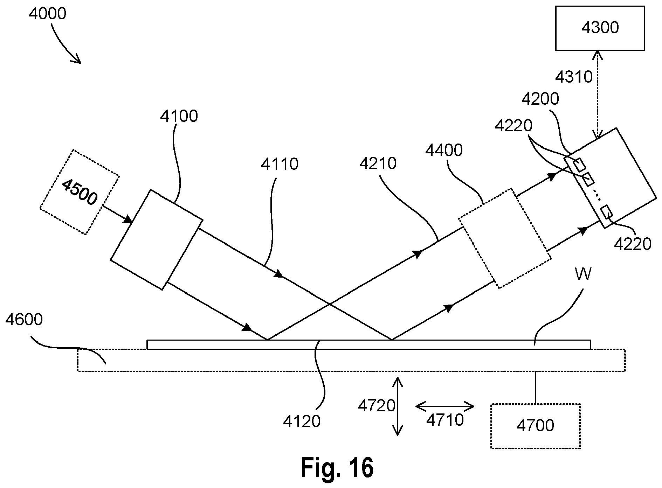

Some embodiments of the present disclosure relate to a new metrology apparatus for determining one or more parameters of a periodic target on an object. An example embodiment of such a new metrology apparatus 4000 is shown schematically in Figure 16.

The new metrology apparatus 4000 shown schematically in Figure 16 may be generally of the form of the metrology apparatus 302 depicted in Figure 6 and described above. The new metrology apparatus 4000 shown schematically in Figure 16 may comprise any combination of features of the metrology apparatus 302 depicted in Figure 6 and described above.

The metrology apparatus 4000 comprises: illumination optics 4100; a detector array 4200; and a controller 4300.

The illumination optics 4100 is arranged to project a radiation beam 4110 onto the object W. The detector array 4200 is arranged to receive a portion of the radiation beam 4210 scattered from the object W and comprising a plurality of diffraction beams. The controller 4300 is operable to determine the one or more parameters in dependence an interference pattern formed in at least one of the plurality of diffraction beams. It will be appreciated that the controller 4300 may be operable to exchange signals 4310 with the detector array 4200.

The metrology apparatus 4000 shown in Figure 16 may be used to carry out the method 1000 shown in Figure 8.

At least one reference mark 2200 may be disposed on the object adjacent to the periodic target 2100. Each of the plurality of diffraction beams may comprise a first portion of radiation scattered from the periodic target 2100 and a second portion of radiation scattered from the reference mark 2200.

The detector array 4200 comprises a plurality of detector elements 4220. For example, the detector array 4200 may comprise a two-dimensional array of detector elements 4220. Each of the plurality of detector elements 4220 is operable to determine a dose of a portion of received scattered radiation 4210. The detector array 4200 may be referred to as a camera. Each of the plurality of detector elements 4200, or a measurement made thereby, may alternatively be referred to as a pixel.

Optionally, the metrology apparatus 4000 may further comprise detection optics 4400 arranged to receive at least a portion of radiation 4210 scattered by the object W and to direct this to the detector array 4200.

The illumination optics 4100 may be arranged to focus the radiation beam 4110 on the object W. That is, the object W may be disposed at, or close to, a beam waist of the radiation 4110. For such embodiments, the detector array 4200 may be disposed in the far field. In particular, the detector array 4200 may be disposed at a position that is not within the Rayleigh length of the radiation from the object W.

The detector array 4200 may be arranged such that it can resolve the interference pattern formed by the periodic target 2100 and an adjacent reference pattern 2200. As discussed above, such an interference pattern may comprise a single dark fringe. To resolve that fringe, the detector array 4200 may be disposed at a position such that at least three sensing elements (pixels) 4220 of the detector array 4200 span the full width at half-maximum (FWHM) of a spot region corresponding to the diffraction order in which the interference pattern is formed.

The controller 4300 may be operable to carry out any of the steps of any one of the metrology methods described above.

Optionally, the metrology apparatus 4000 may further comprise a radiation source 4500 operable to generate the radiation beam. The radiation source 4500 may comprise a seed source, for example a laser, operable to generate seed radiation having a first wavelength. The radiation source 4500 may comprise a conversion module arranged to convert at least a portion of the seed radiation into a plurality of different radiation components. The conversion of at least a portion of the seed radiation into a plurality of different radiation components may be achieved using high harmonic generation.

The radiation source 4500 may be generally of the form of the illumination source 310 shown in Figure 6 (as described above) and/or the illumination source 600 shown in Figure 7 (as described above). The radiation source 4500 may comprise any combination of features of the illumination source 310 shown in Figure 6 and/or the illumination source 600 shown in Figure 7.

In some embodiments, the radiation 4110 may comprise soft x-rays. It will be appreciated that the radiation 4110 comprises sufficiently coherent radiation to produce the at least one interference pattern.

In some embodiments, the radiation beam 4110 may comprise radiation in a spectral range of 10-20 nm. In some embodiments, the radiation 4110 may comprise a plurality of discrete wavelength components.

Optionally, the metrology apparatus 4000 may further comprising a support 4600 for supporting an object W such that it is positionable such that the illumination optics 4100 can project the radiation beam 4110 onto the object W. The support 4600 for supporting a substrate W may comprise a substrate holder operable to secure the substrate. For example, the support 4600 may comprise a clamp for clamping the substrate to the support. The support 4600 may comprise a stage such as a wafer stage.

Optionally, in some embodiments, the metrology apparatus 4000 may further comprise a movement mechanism 4700 operable to cause relative movement of the support 4600 and the illumination optics 4100. Such movement is indicated schematically in Figure 16 by arrows 4710, 4720. This may allow the object or substrate W to be stepped or scanned through a beam spot region 4120 of the illumination optics 4100. As used herein scanning of an object W is intended to mean continuous movement of the object W. As used herein stepping of an object W is intended to mean movement of the object W in a plurality of successive (temporally separated) steps.

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent numbered clauses:

1. A metrology method for determining one or more parameters of a periodic target on an object, the periodic target being adjacent to a reference mark having a pitch equal to that of the periodic target, the method comprising:

projecting radiation onto the object such that a first portion of the radiation is incident on the periodic target and a second portion of the radiation is incident on the reference mark;
measuring at least one interference pattern formed by contributions to a single diffraction order from both the first and second portions of radiation; and
determining the one or more parameters in dependence on the at least one interference pattern.

2. The metrology method of clause 1 wherein determining the one or more parameters from the at least one interference pattern comprises:
for each at least one interference pattern, determining phase difference between the contributions to the diffraction beam from the first and second portions of radiation.

3. The metrology method of clause 1 or clause 2 wherein determining the one or more parameters from the at least one interference pattern comprises:
for each at least one interference pattern, determining a position of the interference pattern.

4. The metrology method of any preceding clause wherein determining the one or more parameters from the at least one interference pattern comprises:

fitting an expected distribution to the intensity distribution in a spot region corresponding to that diffraction beam in a direction that corresponds to a separation direction of the periodic target and the reference mark; and
determining the one or more parameters of the periodic target from one or more parameters of the expected distribution.

5. The metrology method of any preceding clause wherein the radiation comprises radiation in a spectral range of 10-20 nm.

6. The metrology method of any preceding clause wherein the radiation comprises a plurality of discrete wavelength components.

7. The metrology method of clause 6 wherein the method comprises:

measuring at least one interference pattern for each of the plurality of discrete wavelength components, each of the at least one interference patterns being formed by contributions to a single diffraction order for a single discrete wavelength component from both the first and second portions of radiation; and
determining the one or more parameters from the at least one interference pattern for each of the plurality of discrete wavelength components.

8. The metrology method of any preceding clause wherein the method comprises:

measuring a plurality of interference patterns, each one formed by contributions to a single diffraction order from both the first and second portions of radiation; and
determining the one or more parameters from the plurality of interference patterns.

9. The metrology method of any preceding clause wherein a shearing direction of each of the periodic target and reference mark is perpendicular to a separation direction of the periodic target and the reference mark.
10. The metrology method of any preceding clause wherein determining the one or more parameters comprises using a trained machine learning model.
11. The metrology method of clause 10 wherein the method further comprises training the machine learning model using training data.
12. The metrology method of any preceding clause wherein determining the one or more parameters comprises, for each at least one interference pattern:

using a model-based reconstruction of the reference mark to determine a phase response of the contribution to that interference pattern from the reference mark; and
combining the determined phase response with the interference pattern so as to determine a phase response of the contribution to that interference pattern from the periodic target.

13. The metrology method of any preceding clause further comprising generating the radiation.
14. The metrology method of any preceding clause wherein the method further comprises:

projecting radiation onto the object such that it is incident on the periodic target;
measuring at least one diffraction beam; and
determining the one or more parameters in dependence on the at least one diffraction beam.

15. The metrology method of any preceding clause wherein the method further comprises:

projecting radiation onto the object such that it is incident on the reference mark;
measuring at least one reference diffraction beam; and
determining the one or more parameters in dependence on the at least one reference diffraction beam.

16. The metrology method of any preceding clause wherein the periodic target is adjacent to a second reference mark having a pitch equal to that of the periodic target, the second reference mark having a fixed, non-zero spatial phase shift relative to the reference mark, and wherein the method further comprises:

projecting radiation onto the object such that a first portion of the radiation is incident on the periodic target and a second portion of the radiation is incident on the second reference mark;
measuring at least one second interference pattern formed by contributions to a single diffraction order from both the first and second portions of radiation; and
determining the one or more parameters in dependence on the at least one second interference pattern.

17. The metrology method of clause 16 wherein the method further comprises:

projecting radiation onto the object such that it is incident on the second reference mark;
measuring at least one second reference diffraction beam; and
determining the one or more parameters in dependence on the at least one second reference diffraction beam.

18. A metrology apparatus for determining one or more parameters of a periodic target on an object, the metrology apparatus comprising:

illumination optics arranged to project a radiation beam onto the object;

a detector array arranged to receive a portion of the radiation beam scattered from the object comprising at least one diffraction beam; and

a controller operable to determine the one or more parameters in dependence an interference pattern formed in at least one of the plurality of diffraction beams.

19. The metrology apparatus of clause 18 wherein the illumination optics is arranged to focus the radiation beam on the object.

20. The metrology apparatus of clause 18 of clause 19 wherein the controller is operable to carry out any of the steps of any one of clauses 1 to 17.

21. The metrology apparatus of any one of clauses 18 to 20 further comprising a radiation source operable to generate the radiation beam.

22. The metrology apparatus of one of clauses 18 to 21 wherein the radiation beam comprises radiation in a spectral range of 10-20 nm.

23. The metrology apparatus of one of clauses 18 to 22 wherein the radiation comprises a plurality of discrete wavelength components.

24. The metrology apparatus of any one of clauses 18 to 23 further comprising a support for supporting an object such that it is positionable such that the illumination optics can project the radiation beam onto the object.

25. The metrology apparatus of clause 24 further comprising a movement mechanism operable to cause relative movement of the support and the illumination optics.

26. A computer-readable medium having instructions for carrying out the method of any one of clauses 1 to 17.

27. A measurement target for determination of one or more parameters of a manufacturing process, the measurement target comprising:

a periodic target;

a first reference mark adjacent to the periodic target and having a pitch equal to that of the periodic target; and

a second reference mark adjacent to the periodic target and having a pitch equal to that of the periodic target, the second reference mark having a fixed, non-zero spatial phase shift relative to the reference mark.

28. The measurement target of clause 27 wherein one or more patterns are formed on the object in process layers which spatially overlap with the reference mark and/or the second reference mark wherein the one or more patterns have a pitch which is different to that of the reference mark and the second reference mark.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquidcrystal displays (LCDs), thin film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 1-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

**Claims**

1. A metrology method for determining one or more parameters of a periodic target on an object, the periodic target being adjacent to a reference mark having a pitch equal to that of the periodic target, the method comprising:

   projecting radiation onto the object such that a first portion of the radiation is incident on the periodic target and a second portion of the radiation is incident on the reference mark;
   measuring at least one interference pattern formed by contributions to a single diffraction order from both the first and second portions of radiation; and
   determining the one or more parameters in dependence on the at least one interference pattern.

2. The metrology method of claim 1 wherein determining the one or more parameters from the at least one interference pattern comprises:
   for each at least one interference pattern, determining phase difference between the contributions to the diffraction beam from the first and second portions of radiation.

3. The metrology method of claim 1 or claim 2 wherein determining the one or more parameters from the at least one interference pattern comprises:
   for each at least one interference pattern, determining a position of the interference pattern.

4. The metrology method of any preceding claim wherein determining the one or more parameters from the at least one interference pattern comprises:

   fitting an expected distribution to the intensity distribution in a spot region corresponding to that diffraction beam in a direction that corresponds to a separation direction of the periodic target and the reference mark; and
   determining the one or more parameters of the periodic target from one or more parameters of the expected distribution.

5. The metrology method of any preceding claim wherein the radiation comprises radiation in a spectral range of 10-20 nm.

6. The metrology method of any preceding claim wherein the radiation comprises a plurality of discrete wavelength components.

7. The metrology method of claim 6 wherein the method comprises:

   measuring at least one interference pattern for each of the plurality of discrete wavelength components, each of the at least one interference patterns being formed by contributions to a single diffraction order for a single discrete wavelength component from both the first and second portions of radiation; and
   determining the one or more parameters from the at least one interference pattern for each of the plurality of discrete wavelength components.

8. The metrology method of any preceding claim wherein the method comprises:

   measuring a plurality of interference patterns, each one formed by contributions to a single diffraction order from both the first and second portions of radiation; and
   determining the one or more parameters from the plurality of interference patterns.

9. The metrology method of any preceding claim wherein a shearing direction of each of the periodic target and reference mark is perpendicular to a separation direction of the periodic target and the reference mark.

10. The metrology method of any preceding claim wherein determining the one or more parameters comprises using a trained machine learning model.

11. The metrology method of any preceding claim wherein determining the one or more parameters comprises, for each at least one interference pattern:

    using a model-based reconstruction of the reference mark to determine a phase response of the contribution to that interference pattern from the reference mark; and
    combining the determined phase response with the interference pattern so as to determine a phase response of the contribution to that interference pattern from the periodic target.

12. The metrology method of any preceding claim wherein the periodic target is adjacent to a second reference mark having a pitch equal to that of the periodic target, the second reference mark having a fixed, non-zero spatial phase shift relative to the reference mark, and wherein the method further comprises:

    projecting radiation onto the object such that a first portion of the radiation is incident on the periodic target and a second portion of the radiation is incident on the second reference mark;
    measuring at least one second interference pattern formed by contributions to a single diffraction order from both the first and second portions of radiation; and
    determining the one or more parameters in dependence on the at least one second interference pattern.

13. A metrology apparatus for determining one or more parameters of a periodic target on an object, the metrology apparatus comprising:

    illumination optics arranged to project a radiation beam onto the object;
    a detector array arranged to receive a portion of the radiation beam scattered from the object comprising at least one diffraction beam; and
    a controller operable to determine the one or more parameters in dependence an interference pattern formed in at least one of the plurality of diffraction beams.

14. A computer-readable medium having instructions for carrying out the method of any one of claims 1 to 12.

15. A measurement target for determination of one or more parameters of a manufacturing process, the measurement target comprising:

    a periodic target;
    a first reference mark adjacent to the periodic target and having a pitch equal to that of the periodic target; and
    a second reference mark adjacent to the periodic target and having a pitch equal to that of the periodic target, the second reference mark having a fixed, non-zero spatial phase shift relative to the reference mark.

EP 4 589 380 A1

**Fig. 1**

**Fig. 2**

**Fig. 3**

**Fig. 4**

**Fig. 5**

**Fig. 6**

**Fig. 7**

1000

1100

1200

1300

Fig. 8

2000

2100          2200

2322

2320

2310

2312

2300

2400

Fig. 9

**Fig. 10**

3000

3100

3200  3202  3206  3210
     3204  3208

x

y

**Fig. 11A**

3300

3400

3500  3502  3506  3510
     3504  3508

x

y

**Fig. 11B**

3600

3700

3802  3800

x

y

**Fig. 11C**

Fig. 12A

Fig. 12B

Fig. 13A

Fig. 13B

Fig. 14

Fig. 15

**Fig. 16**

## EUROPEAN SEARCH REPORT

**Application Number**

EP 24 15 2530

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/024054 A1 (MOON EUCLID EBERLE [US] ET AL) 25 January 2018 (2018-01-25) | 13 | INV.<br>G03F7/00 |
| Y | * paragraph [0005] *<br>* paragraphs [0063] - [0072]; figures 3a,4,5 *<br>* paragraphs [0100] - [0103]; figures 9-12 *<br>* paragraphs [0132] - [0138]; figures 15, 30-32,33c *<br>* paragraphs [0188] - [0192] * | 1-12,14, 15 | G01N21/95 |
| Y | US 2015/204664 A1 (BRINGOLTZ BARAK [IL] ET AL) 23 July 2015 (2015-07-23)<br>* paragraph [0007] *<br>* paragraphs [0110] - [0115]; figure 13 *<br>* paragraphs [0150] - [0158]; figures 8E, 8F *<br>* paragraphs [0181] - [0185]; figures 12A-12C * | 1-12,14, 15 | |
| Y | US 2023/213871 A1 (GOORDEN SEBASTIANUS ADRIANUS [NL] ET AL)<br>6 July 2023 (2023-07-06)<br>* paragraphs [0092] - [0094]; figure 5 *<br>* paragraphs [0107] - [0130]; figures 8-12 * | 2-4,6-8 | **TECHNICAL FIELDS SEARCHED (IPC)**<br><br>G03F<br>G01N |
| Y | US 2023/040124 A1 (NIENHUYS HAN-KWANG [NL] ET AL) 9 February 2023 (2023-02-09)<br>* paragraphs [0311] - [0344] * | 10 | |
| Y | WO 2023/222349 A1 (ASML NETHERLANDS BV [NL]) 23 November 2023 (2023-11-23)<br>* paragraphs [0168] - [0174]; figure 16 * | 11 | |
| A | US 2024/003809 A1 (KRAUS PETER MICHAEL [NL] ET AL) 4 January 2024 (2024-01-04)<br>* paragraphs [0081] - [0114]; figure 10 * | 1-15 | |

The present search report has been drawn up for all claims

| Place of search | Date of completion of the search | Examiner |
|---|---|---|
| Munich | 17 July 2024 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 15 2530

This annex lists the patent family members relating to the patent documents cited in the above-mentioned European search report.
The members are as contained in the European Patent Office EDP file on
The European Patent Office is in no way liable for these particulars which are merely given for the purpose of information.

17-07-2024

| Patent document cited in search report | Publication date | Patent family member(s) | Publication date |
|---|---|---|---|
| US 2018024054 A1 | 25-01-2018 | CN 109564391 A | 02-04-2019 |
| | | IL 263766 A | 31-01-2019 |
| | | JP 6716779 B2 | 01-07-2020 |
| | | JP 2019523449 A | 22-08-2019 |
| | | KR 20190031542 A | 26-03-2019 |
| | | TW 201812473 A | 01-04-2018 |
| | | US 2018024054 A1 | 25-01-2018 |
| | | WO 2018015179 A1 | 25-01-2018 |
| US 2015204664 A1 | 23-07-2015 | US 2015204664 A1 | 23-07-2015 |
| | | US 2016216197 A1 | 28-07-2016 |
| | | WO 2014062972 A1 | 24-04-2014 |
| US 2023213871 A1 | 06-07-2023 | CN 115698861 A | 03-02-2023 |
| | | US 2023213871 A1 | 06-07-2023 |
| | | WO 2021239479 A1 | 02-12-2021 |
| US 2023040124 A1 | 09-02-2023 | CN 114902139 A | 12-08-2022 |
| | | IL 293749 A | 01-08-2022 |
| | | KR 20220103772 A | 22-07-2022 |
| | | TW 202138927 A | 16-10-2021 |
| | | TW 202227905 A | 16-07-2022 |
| | | US 2023040124 A1 | 09-02-2023 |
| | | WO 2021121906 A1 | 24-06-2021 |
| WO 2023222349 A1 | 23-11-2023 | TW 202411775 A | 16-03-2024 |
| | | WO 2023222349 A1 | 23-11-2023 |
| US 2024003809 A1 | 04-01-2024 | CN 116490766 A | 25-07-2023 |
| | | EP 4006640 A1 | 01-06-2022 |
| | | TW 202235854 A | 16-09-2022 |
| | | US 2024003809 A1 | 04-01-2024 |
| | | WO 2022111905 A1 | 02-06-2022 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006066855 A1
- US 2011102753 A1
- US 20120044470 A
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B

- US 13033135 B
- US 13533110 B
- US 13891410 B
- WO 2011012624 A
- US 20160161863 A
- US 20160370717 A1
- US 2007224518 A
- US 2019003988 A1
- US 2019215940 A1
- US 20130304424 A1
- US 2014019097 A1, Bakeman
- US 20170184981 A1
- US 2016282282 A1

**Non-patent literature cited in the description**

- **LEMAILLET et al.** Intercomparison between optical and X-ray scatterometry measurements of FinFET structures. *Proc. of SPIE*, 2013, 8681